# EUROPEAN PATENT SPECIFICATION

(11) **EP 2 683 516 B1**
(45) Date of publication and mention of the grant of the patent: **06.09.2017**
(21) Application number: 12714825.2
(22) Date of filing: 01.03.2012
(51) Int. Cl.: G03F 7/20, B23K 26/00, B23K 26/06, B23K 26/046, B23K 26/067, B23K 26/361, B23K 26/082, B23K 26/0622, B23K 26/362

(54) **LASER FABRICATION SYSTEM AND METHOD**
LASERHERSTELLUNGSSYSTEM UND VERFAHREN
SYSTÈME ET PROCÉDÉ DE FABRICATION LASER

(30) Priority: 07.03.2011 GB 201103814
(43) Date of publication of application: 15.01.2014
(73) Proprietor: Oxford University Innovation Limited, Botley Oxford OX2 0JB (GB)
(72) Inventor: BOOTH, Martin James, Oxford, Oxfordshire OX2 7SG (GB); SALTER, Patrick Stephen, Oxford, Oxfordshire OX2 7SG (GB)
(74) Representative: Ertl, Nicholas Justin
(86) International application number: PCT/GB2012/050462
(87) International publication number: WO 2012/120280

(56) References cited:
- US-A1- 2009 296 064
- US-A1- 2010 079 832
- US-B1- 6 625 181

## Description

This invention relates to laser fabrication systems and methods, and in particular to a laser fabrication system and method for simultaneous processing of a sample at multiple sites in parallel, in order to reduce the processing time.

Laser machining is widely applied industrially and scientifically to process a range of materials. In its simplest implementation, a high power laser is used to cut materials such as steel to a high accuracy leaving an edge with a high quality surface finish. Laser machining is also applied to more delicate procedures, such as direct laser lithography. By using tight focussing optics and short pulsed lasers, micron and sub-micron scale feature sizes may be achieved, in addition to three dimensional resolution. These capabilities can be used, for example, to fabricate structures with unusual and useful optical properties, including photonic crystals, metamaterials, waveguide structures, microfluidic devices and functional micro-components.

Most laser fabrication systems use a single focussed laser beam to machine or fabricate material in a sequential fashion. The speed can however be increased by using many focal spots in parallel. It is known that parallelised fabrication with hundreds of spots can be implemented using microlens arrays that create a multitude of focal spots. In laser 3D microfabrication, there are several examples of parallelisation that employ a microlens array to split a laser beam into multiple fabrication spots. One example is described in the article "Multiple-spot parallel processing for laser micronanofabrication" by J. Kato, N. Takeyasu, Y. Adachi, H. Sun and S. Kawata, App. Phys. Lett., 86, 044102 (2005).

In this type of fabrication system, the array of focal points is fixed and the individual focal spots cannot be controlled independently.

This approach generates multiple spots by means of optical paths through lenses. Alternatively, holographic patterns created by diffractive optical elements can be used to split a laser beam into many focal points. In this case, the pattern of focal points can be selected, and then translated into the design of the diffractive optical elements. This approach can also be more versatile, by using adaptive (i.e. controllable) diffractive elements to create the desired pattern of focal points, such as spatial light modulators.

An example of this type of holographic projection for the generation of multiple fabrication focal points is described in the article "Arbitrary micropatterning method in femtosecond laser microprocessing using diffractive optical elements", by Y. Kuroiwa, N. Takeshima, Y. Narita, S. Tanaka, and K. Hirao, Opt. Exp. 12, 1908 (2004).

However, these diffractive optical elements suffer from wavelength dependence and hence chromatic aberration. This along with other device limitations restricts the number of focal spots that can be created in parallel.

US 2009/0296064 A1 discloses a laser fabrication system comprising a laser, a spatial light modulator, a microlens array and focusing optics for generating a set of focal regions in a sample to be processed.

According to a first aspect of the present invention, there is provided a laser fabrication system as recited in claim 1 below. According to a second aspect of the present invention, there is provided a laser fabrication method as recited in claim 9 below. Dependent claims therefrom define particular embodiments of the present invention.

There is provided a laser fabrication system for processing a sample, comprising:
a laser;
a controllable light processing unit comprising an array of control regions, for independently controlling a light characteristic of light output from each control region;
a microlens array in the optical path of the light output from the control regions of the light processing unit; and
focusing optics for generating a set of focal regions in a sample to be processed, one focal region associated with each microlens.

This arrangement combines the ability to generate multiple focal spots in the sample being processed by means of a microlens array, and additionally enables individual spots to be controlled, by means of the light processing unit, which functions as an adaptive optical element.

This control of the individual spots can involve changing the intensity or position, or even generating a pattern of focal points for focusing by each microlens.

The controllable light processing unit preferably comprises a spatial light modulator. This can be used to alter the light intensity or polarization on a pixel-by-pixel basis, but in a preferred implementation, the spatial light modulator comprises an array of pixels, and each pixel is controllable to vary the phase of the light output from the pixel. This ability to provide phase control enables various optical effects to be obtained, including amplitude control, direction control as well as the generation of complex phase patterns.

Preferably, each control region is associated with a respective microlens and comprises a sub-array of pixels. The sub-array of pixels can be controllable to a first state for providing a single focus in the focal region, in which light with a uniform phase is output from the control region. Thus, a uniform phase wavefront applied to a microlens is used to generate a single focal point, in conventional manner. A second state provides multiple lower intensity focal points in the focal region. To achieve this, light with a non-uniform phase pattern is output from the control region. By providing reduced-intensity multiple focal points, a threshold at which processing of the sample occurs can be passed, so that the fabrication focal point is effectively turned off, but without having to arrange for the dissipation of the laser energy outside the sample. The sample processing with a threshold function can comprise ablation, photo-initiated polymerisation or photo-induced reduction of metal ions. Other processes can also rely on such a threshold, such as methods relying on a phase change in the material, for example refractive index change in glass or creating graphite structures in diamond.

The non-uniform phase pattern can be achieved with a checkerboard pattern of opposite phase outputs from the individual pixels (of the sub-array), or using a random pattern, for example.

The phase control can be used to provide a shifted main focus in the focal region, by outputting light with a linear phase gradient from the control region. This effectively provides a tilted wavefront, and changes the focal point position of the microlens. By outputting light with a quadratic phase gradient, a defocus function can be implemented.

The phase control can also be used to provide a reduced intensity main focus in the focal region, by outputting light with a uniform phase from a majority of the pixels and light with an opposite phase from the remaining minority of the pixels from the control region. In this case, a selected (relatively small) number of pixels can be switched to an opposite phase (compared to the uniform phase wavefront) to effect a reduction in intensity. This intensity control can be used to provide a more uniform intensity of the focal points across the sample, and thereby compensate for non-uniformities or irregularities in the optical components of the system.

The phase control can be used to generate a desired multiple focal point pattern in the focal region, by using light with a predetermined phase pattern output from the control region. In this way, a holographic phase pattern can be generated for each microlens. By generating a holographic phase pattern on a per-microlens basis, chromatic aberration problems associated with known holographic systems are reduced.

An interferometric system can be provided associated with the spatial light modulator and microlens array, which is arranged to provide constructive or destructive interference at the microlens array.

In the examples above, each control region of the light processing unit is associated with a single microlens, and one control region is used to effect the nature of the focal point (or set of focal points) generated by the associated microlens. However, the spatial light modulator can be controllable (as a whole) to provide a phase pattern output which results in light being directed to some microlenses and not others. Thus, the one-to-one association between microlenses and control regions is not essential.

In one example of this holographic approach, an additional input spatial light modulator is provided. The input spatial light modulator is controllable to provide the phase pattern output which results in light being directed to some regions of the other spatial light modulator and not others. The main spatial light modulator then provides the beam steering and intensity control functions as outlined above on the basis of each microlens / control region.

An optical imaging system can be provided between the controllable light processing unit and the microlens array. This can provide desired magnification between the laser output and microlens array.

The examples outlined above use phase control. However, the controllable light processing unit can comprise a controllable mirror device. This cannot provide all of the possibilities obtainable with phase control, but it can be used to provide intensity control of each microlens focal point independently.

In another example, a spatial light modulator can comprise an array of pixels which vary the polarization of the light output from the pixel. The system then preferably further comprises a polarization beam splitter between the spatial light modulator and the microlens array, for directing light with a predetermined polarization away from the microlens array. There is also provided a laser fabrication method, comprising :
directing a laser output to a controllable light processing unit comprising an array of control regions;
independently controlling a light characteristic of the light output from each control region and directing the light output to a microlens array; and
generating a set of focal regions in a sample to be processed, one focal region associated with each microlens.

As outlined above, in a preferred example, the light characteristic comprises the phase, and the control of a light characteristic of light output from each control region is adapted to:
provide a single focus in the focal region by outputting light with a uniform phase from the control region, or
provide multiple lower intensity focal points in the focal region by outputting light with a non-uniform phase pattern from the control region, or
provide a laterally shifted main focus in the focal region by outputting light with a linear phase gradient from the control region, or
provide a depth-shifted main focus in the focal region by outputting light with a quadratic phase pattern from the control region, or
provide a reduced intensity main focus in the focal region by outputting light with a uniform phase gradient from a majority of the pixels and light with an opposite phase from the remaining minority from the control region, or
generate a desired multiple focal point pattern in the focal region by outputting light with a predetermined phase pattern from the control region, or
provide a phase pattern output which results in light being directed to some microlenses and not others.

Examples of the invention will now be described in detail with reference to the accompanying drawings, in which:
Figure 1 shows schematically a laser fabrication system of the invention;
Figure 2 shows two possible examples of light processing unit used in the system of Figure 1;
Figure 3 shows a first possible optical configuration using a spatial light modulator;
Figure 4 shows a second possible optical configuration using a spatial light modulator;
Figure 5 shows a third possible optical configuration using a polarization based spatial light modulator;
Figure 6 shows an example of phase pattern applied to the spatial light modulator in Figure 3;
Figure 7 shows an example of a set of focal points with some spots deactivated, and the resulting ablation of the sample;
Figure 8 shows a fourth possible optical configuration using a spatial light modulator;
Figure 9 shows how intensity control can be used to generate a uniform spot intensity across the sample;
Figure 10 shows an example of a set of focal points with some spots laterally moved, and the resulting ablation of the sample;
Figure 11 shows a fifth possible optical configuration using a spatial light modulator;
Figure 12 shows a sixth possible optical configuration using a spatial light modulator; and
Figure 13 shows a seventh possible optical configuration using a spatial light modulator.

The invention provides a laser fabrication system for processing a sample, comprising a laser, a controllable light processing unit and a microlens array in the optical path of the light output from the light processing unit. Focusing optics generates a set of focal regions in a sample to be processed, one focal region associated with each microlens. This arrangement combines multiple focal spots in the sample with individual spot control.

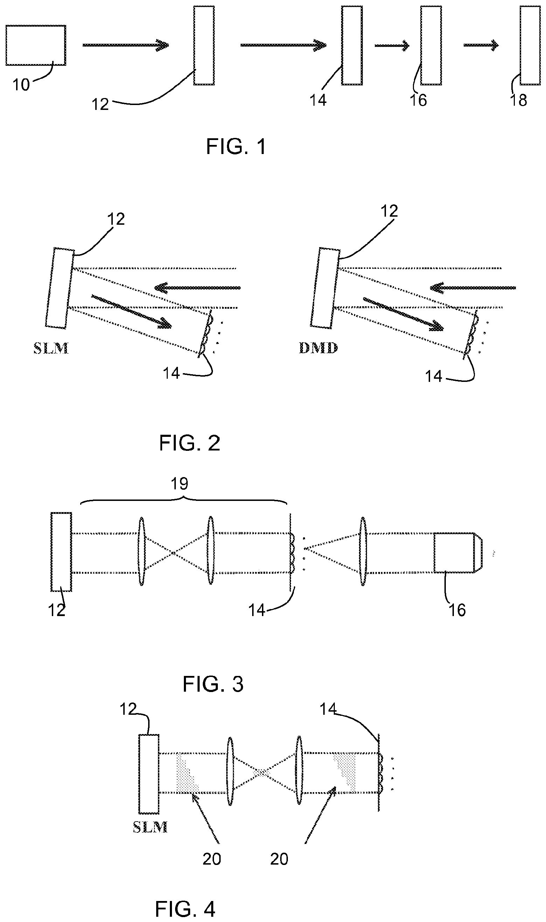

Figure 1 shows schematically a laser fabrication system of the invention.

The system comprises a laser 10, a controllable light processing unit 12, a microlens array 14, and focusing optics 16 for generating a set of focal regions in a sample 18 to be processed. One focal region is associated with each microlens.

The laser can be a femtosecond pulsed laser, for example with an output wavelength of around 800nm and a pulse length of around 100fs. Alternatively, the laser can be a femtosecond pulse fibre laser with a wavelength of around 1000-1100nm. Femtosecond laser fabrication methods are becoming increasing popular for three-dimensional microfabrication.

The unit 12 can take the form of various adaptive optical elements, and comprises an array of control regions, for independently controlling a light characteristic of light output from each control region.

The microlens array 14 is in the optical path of the light output from the control regions of the light processing unit 12, and the multiple focal spots are formed in the sample 18 (mounted on a fabrication substrate) by the focusing optics, which essentially comprises an objective lens.

Figure 2 shows two possible examples of light processing unit used in the system of Figure 1.

In a preferred example, the light processing unit comprises a spatial light modulator (SLM). Indeed, several implementations of a spatial light modulator coupled to a microlens array already exist in other fields, for example for optical interconnects and switches in fibreoptic systems. The spatial light modulator can comprise a liquid crystal spatial light modulator (hereinafter "LCSLM") designed to modulate the phase, amplitude or polarization of an incident light beam, and can operate in transmissive or reflective mode. In Figure 2, a reflective spatial light modulator operating in reflective mode is shown.

Another implementation of spatial light modulator is a digital mirror device (DMD), also shown in Figure 2. A digital mirror device can be used to deflect portions of the beam corresponding to individual lenses onto or off the microlens array. A digital mirror device has the advantage of fast response times.

Digital mirror devices, liquid crystal amplitude-controlling spatial light modulators, liquid crystal phase-controlling spatial light modulators, and liquid crystal polarization-controlling spatial light modulators are all commercially available as off-the-shelf components.

The spatial light modulator 12 can be coupled directly to the microlens array 14. Working in reflection, the incident angle of the beam needs to be within the operating range of the device. For an LCSLM, the distance from the LCSLM to the microlens array also needs to be sufficiently short that diffraction of the beam does not affect the coupling.

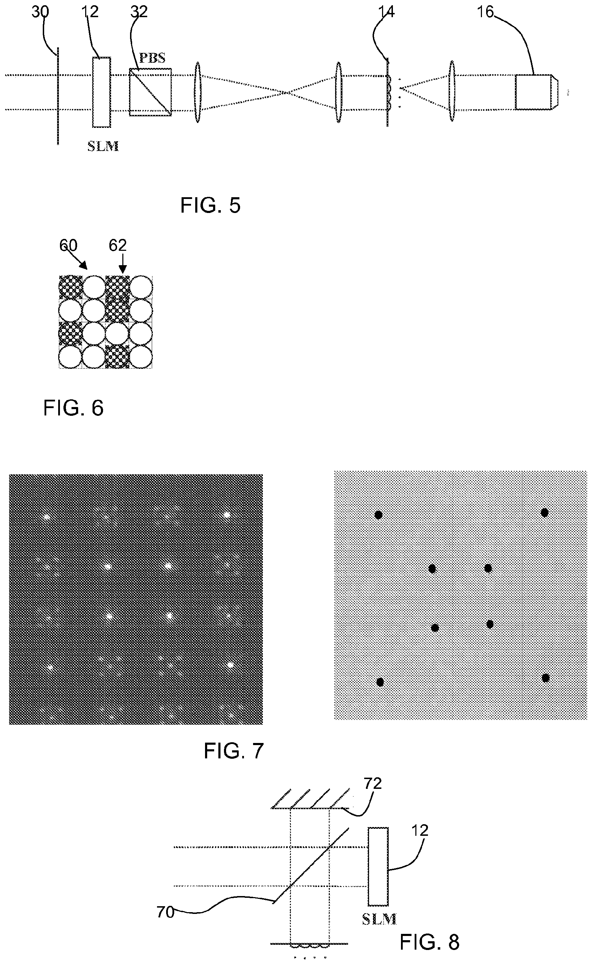

The LCSLM or (digital mirror device) may be coupled to the microlens array using an optical beam splitter. This beam splitter could be used as part of a system which provides amplitude control via polarisation change (as explained below with reference to Figure 5) or interferometric control (as explained below with reference to Figure 8). A beam splitter can also be used for providing optical coupling when using phase control with a reflective SLM.

The LCSLM maybe be imaged onto the microlens array with a 4f lens system 19 as shown in Figure 3. This has the advantage that the effects of diffraction from the LCSLM to the microlens array are limited and the LCSLM can be magnified or de-magnified to appropriately fit the size of the microlens array. The array of focal points from the microlens array can be de-magnified with a microscope to reduce the spot separation and feature fabrication size.

If the lens system of Figure 3 is used for coupling the LCSLM to the microlens array, there may be a high enough intensity at the focus of the 4f lens system for electric field breakdown. This could be removed by temporally spreading the focus with a pair of spatially dependent retarders (or phase plates) without affecting the final beam. This is shown in Figure 4, with the spatially dependent retarders shown as 20.

Figure 5 shows the use of a liquid crystal spatial light modulator (LCSLM) which is used to change the polarisation state of an incident beam. The LCSLM is positioned between a polariser 30 and polarization beam splitter (PBS) 32. The LCSLM is used, in conjunction with the polarising optics, to spatially modulate the intensity of the fabrication beam such that only the lenses needed for fabrication are illuminated. The light directed to the microlens array for lenses which are not to be used has an altered polarization, such that the light is redirected by the beam splitter 32 to a beam dump (not shown).

The preferred implementation of the invention uses a pixellated liquid crystal spatial light modulator, wherein each pixel is controllable to vary the phase of the light output from the pixel. The description below is based on the use of this type of spatial light modulator.

The use of phase control enables various controls to be implemented.

Figure 6 shows how different phase patterns enable the switching of the focal points for individual lenses on or off. This allows the possibility of inkjet style printing, or non-periodic arrays of spots.

The LCSLM has an array of pixels, and each control region comprises a sub-array of pixels. Individual control regions are associated with a respective lens.

The sub-array of pixels can be controllable to a first state for providing a single focus in the focal region, in which light with a uniform phase (a flat phase pattern) is output from the control region. Thus, a uniform phase wavefront applied to a microlens is used to generate a single focal point, in conventional manner.

A second state provides multiple lower intensity focal points in the focal region. To achieve this, light with a non-uniform phase pattern is output from the control region. By providing reduced-intensity multiple focal points, a threshold at which ablation of the sample occurs can be passed, so that the fabrication focal point is effectively turned off, but without having to arrange for the dissipation of the laser energy outside the sample.

A binary chequer board phase pattern can be applied to control regions of the LCSLM for lenses corresponding to those spots not required for fabrication. The binary chequerboard creates four main diffraction orders spatially separated from the natural focus of the lens, in addition to subsidiary diffraction orders.

Figure 6 shows the LCSLM with some regions with a flat phase output (the white circles 60) and some with the binary checkerboard (circles 62). Typically, there may be a sub-array of 30x30 pixels (i.e. 900 pixels) per lens of the microlens array. There may be 20x20 lenses in the microlens array, but this can be scaled up to enable large scale device fabrication.

The checkerboard pattern does not need to be on a per-pixel basis, but will have dimensions to create the desired shifting of the diffraction orders and attenuation of the zeroth order diffraction. For example, the period of the checkerboard pattern may be of the order of 240µm (12 pixels for in the case of a 20µm pixel pitch)

Figure 7 shows the resulting focal point pattern (left image) with some lenses activated (giving a single central bright focal point) and some lenses deactivated (giving multiple dim focal points resulting from higher diffraction orders). All of the higher diffraction orders are lower in intensity than the corresponding focal spot when a flat phase is applied to the LCSLM.

By suitable adjustment of the chequerboard period on the LCSLM and the incident beam intensity, and taking advantage of the strong threshold phenomenon in non-linear optical fabrication, the diffraction orders have insufficient intensity for fabrication. In effect, the pattern causes spots to be switched off for the purposes of fabrication. The right image in Figure 7 shows the resulting ablation sites in the sample, and shows how the threshold effect influences the fabrication process. This example shows the fabrication of voids in fused silica.

The chequerboard pattern may be replaced by a different pattern (e.g. a random phase pattern).

Figure 8 shows how the LCSLM may be used in combination with a beam splitter 70 and reference mirror 72 in an interferometric system, which controls the intensity incident on each lens in the array. By applying a phase shift to the LCSLM destructive or constructive interference can be engineered at the plane of the microlens array at lenses corresponding to focal points that are to be deactivated or activated for fabrication.

The phase control can also be used to implement an Intensity control function. This can be used to compensate for non-uniformity in the illumination beam or irregularities in the microlens array. The intensity of individual focal points can be adjusted such that the intensities across the array of focal points are uniform. Alternatively it may be desired that a stronger fabrication effect is required in some regions as opposed to others, when again it would be useful to adjust the intensity of individual spots. To reduce the intensity of an individual focus the phase of one or more randomly chosen pixels of the respective sub-array is reversed by pi radians. The intensity of the focus depends linearly on the number of pixels reversed.

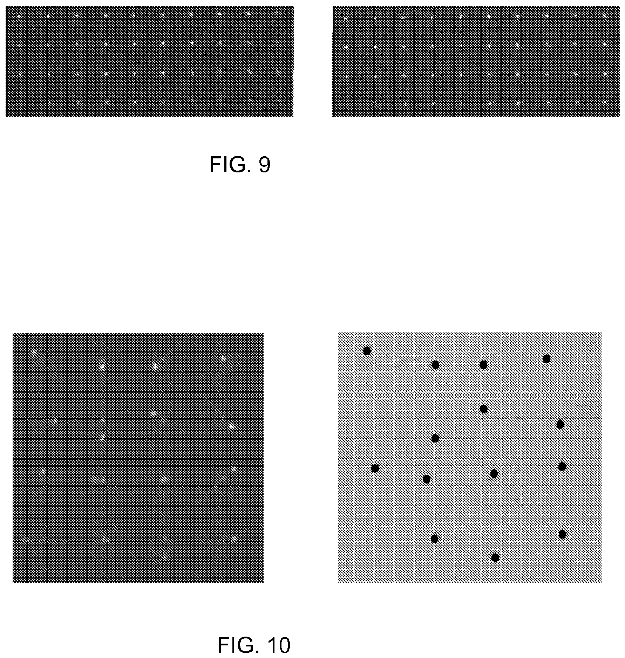

Figure 9 shows in the left image an array of focal points with non-uniform intensity, and the right image shows the array of focal points after adjustment for uniform intensity. For example, the intensity of all focus spots can be reduced until they all correspond to the spot with the lowest intensity.

Beam steering can also be implemented. By applying suitable phase patterns to the LCSLM, the focus from an individual lens may be shifted from its natural position.

Constant phase gradients are required for a transverse shift of the focal point position, while a quadratic phase profile may be applied to implement a defocus. This defocus can be used to ensure that all the spots are in the same focal plane, or to implement a scanning in the z-axis (sample depth) direction.

With sufficient LCSLM pixels in each sub-array, all of the space within the array may be covered by the focal points. As a focus is shifted from its natural position, there is an associated drop in intensity related to pixellation and phase wrapping at the LCSLM. The intensity of the spots as a function of position can be adjusted in order to compensate for non-uniformities as explained with reference to Figure 9.

Figure 10 shows in the left image an array of focal points with different focal points shifted in different directions from the natural focal point. This shift is associated with the creation of additional lower intensity spots resulting from higher orders of diffraction as well as the zero order, and these can also be seen. The right image shows the fabrication sites, which again are limited to the main focal points as a result of the threshold in the ablation process.

In the examples above, each microlens is used to form a corresponding single focal point, and the optical signal reaching each microlens is controlled by a respective control region of the LCSLM. However, phase holograms may be projected through individual lenses such that there are multiple fabrication spots per lens. This has an advantage over purely holographic beam shaping as the degree of chromatic aberration is reduced and a greater number of practically applicable fabrication spots can be generated than with a hologram alone. For example, a regular grid of focus spots may be generated for each microlens, to increase further the amount of parallelisation and potential speed of fabrication.

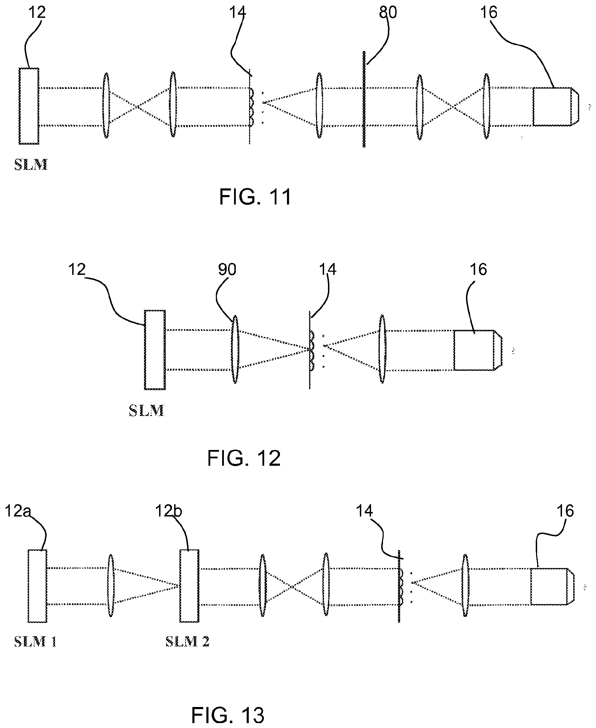

This arrangement can be combined with adaptive aberration correction. Optical aberrations can be a serious problem in laser microfabrication, in particular related to a refractive index mismatch between the objective immersion medium and the substrate. Aberration correction may be implemented by application of a correction phase function to each lens individually using the appropriate region of the LCSLM. Figure 11 shows an example in which aberration correction is applied to the beam as a whole through insertion of an additional adaptive element such as a deformable mirror 80 following the microlens array 14.

A further implementation of the setup can use a phase hologram displayed on the LCSLM to direct light onto particular lenses of the microlens array while not others. This removes the direct association between control regions of the LCSLM and the microlenses. The LCSLM is then controllable (as a whole) to provide a phase pattern output which results in light being directed to some microlenses and not others.

As shown in Figure 12, the hologram can be projected onto the plane of the microlens array with an achromatic doublet lens 90. The hologram may be designed in such a manner as to also correct for phase at the plane of the microlens array. However, an improvement is to use two LCSLMs coupled together as shown in Figure 13.

An additional LCSLM 12a is used to project a phase hologram which selectively illuminates regions of the second LCSLM 12b associated with lenses in the microlens array that are required for fabrication. The second LCSLM 12b functions in the manner explained above, and can for example be used to correct for aberration, adjust the intensity of the focal points, and provide beam steering.

In order to enable fabrication of any shape (2D or 3D), the focused fabrication spots need to be adjustable in position with respect to the sample so that the entire space between fabrication spots is covered. This can be achieved with a movable fabrication support.

However, the ability to steer the focal spot as explained above can either avoid the need for x-y position control, or it can reduce the range of movement needed. Similarly, the ability to implement focal depth control can either avoid the need for position z control, or it can reduce the range of movement needed, or it provides the ability to fabricate simultaneously on a non-planar surface.

It is possible to enable position control only in one of the x and y directions, by selecting a direction of movement which is not parallel to the row or column direction of the focal points. A single scan direction can then enable the full area to be scanned. This enables a laser fabrication process similar to a scanning inkjet printing process.

The invention can be applied to any laser fabrication process, including 2D surface processing or 3D volume processing. The invention is of particular interest for three-dimensional microfabrication.

The invention can for example be used for fabrication of waveguides, photonic crystals and microfluidic devices.

Various laser frequencies, pulse durations and pulse repetition rates can be used. In one example, a regeneratively amplified titanium sapphire laser can be used with 100fs pulse duration and 1 kHz repetition rate. The LCSLM can be any commercially available device, for example suitable reflective phase-only devices are currently available from Hamamatsu Photonics.

However, the approach of the invention, to combine multiple spot creation using a microlens array and individual spot control, can be applied to other laser fabrication processes, including femtosecond, picosecond, or nanosecond laser fabrication or even continuous wave laser fabrication processes.

The microlens array is also conventional, and can by way of example comprise a square array of piano-convex lenses with a 500µm pitch and focal length 15.5mm. The pitch will be selected according to the number of pixels desired per microlens and may be much smaller.

As is clear from the description above, the light characteristic that is controlled by the light processing unit is preferably the phase, but it can also be the direction of propagation (in the case of a mirror device), the polarisation state or the amplitude.

Various modifications will be apparent to those skilled in the art.

## Claims

1. A laser fabrication system for processing a sample, comprising:
a laser (10);
a controllable light processing unit (12) comprising a spatial light modulator which comprises an array of pixels, with each pixel controllable to vary the phase of the light output from the pixel, wherein the light processing unit comprises an array of control regions, for independently controlling a light characteristic of the light output from each control region;
a microlens array (14) in the optical path of the light output from the control regions of the light processing unit; and
focusing optics (16) for generating a set of focal regions in a sample to be processed, one focal region associated with each microlens,
wherein each control region is associated with a respective microlens, **characterized in that**
each control region comprises a sub-array of pixels, wherein each sub-array of pixels is controllable to a first state for providing a single focus in the focal region, in which light with a uniform phase is output from the control region, and a second state for providing multiple lower intensity focal points in the focal region, in which light with a non-uniform phase pattern is output from the control region.

2. A system as claimed in claim 1, wherein each sub-array of pixels is controllable to a further state for providing a shifted main focus in the focal region, in which a light with a linear phase gradient is output from the control region.

3. A system as claimed in claim 1 or 2, wherein each sub-array of pixels is controllable to a further state for providing a reduced intensity main focus in the focal region, in which light with a uniform phase from a majority of the pixels and light with an opposite phase from the remaining minority of the pixels is output from the control region.

4. A system as claimed in any preceding claim, wherein each sub-array of pixels is controllable to generate a desired multiple focal point pattern in the focal region, in which light with a predetermined phase pattern is output from the control region.

5. A system as claimed in any preceding claim, further comprising an interferometric system associated with the spatial light modulator and microlens array, and which is arranged to provide constructive or destructive interference at the microlens array.

6. A system as claimed in any preceding claim, wherein the spatial light modulator is controllable to provide a phase pattern output which results in light being directed to some microlenses and not others.

7. A system as claimed in any one of claims 1 to 5, comprising an additional input spatial light modulator, wherein the input spatial light modulator is controllable to provide a phase pattern output which results in light being directed to some regions of the other spatial light modulator and not others.

8. A system as claimed in any preceding claim, comprising an optical imaging system between the controllable light processing unit and the microlens array.

9. A laser fabrication method, comprising:
directing a laser output to a controllable light processing unit comprising a spatial light modulator which comprises an array of pixels, with each pixel controllable to vary the phase of the light output from the pixel, wherein the light processing unit comprises an array of control regions;
independently controlling a light characteristic of the light output from each control region and directing the light output to a microlens array, wherein the light characteristic comprises the phase, and wherein each control region is associated with a respective microlens and comprises a sub-array of pixels; generating a set of focal regions in a sample to be processed, one focal region associated with each microlens, and
controlling each sub-array of pixels to a first state for providing a single focus in the focal region, in which light with a uniform phase is output from the control region, and to a second state for providing multiple lower intensity focal points in the focal region, in which light with a non-uniform phase pattern is output from the control region.

10. A method as claimed in claim 9 wherein the control of a light characteristic of light output from each control region is further adaptable to:
provide a laterally shifted main focus in the focal region by outputting light with a linear phase gradient from the control region, or
provide a depth-shifted main focus in the focal region by outputting light with a quadratic phase pattern from the control region, or
provide a reduced intensity main focus in the focal region by outputting light with a uniform phase gradient from a majority of the pixels and light with an opposite phase from the remaining minority from the control region, or
generate a desired multiple focal point pattern in the focal region by outputting light with a predetermined phase pattern from the control region, or
provide a phase pattern output which results in light being directed to some microlenses and not others.

## Patentansprüche

1. Laserfertigungsverfahren zum Verarbeiten eines Musters, umfassend:
einen Laser (10);
eine steuerbare Lichtverarbeitungseinheit (12) umfassend einen räumlichen Lichtmodulator, der eine Pixel-Anordnung umfasst, wobei jedes Pixel steuerbar ist, um die Phase des Lichtausgangs von dem Pixel zu variieren, wobei die Lichtverarbeitungseinheit eine Anordnung von Steuerregionen umfasst, um eine Lichteigenschaft des Lichtausgangs von jeder Steuerregion unabhängig zu steuern;
eine Mikrolinsenanordnung (14) im optischen Pfad des Lichtausgangs von den Steuerregionen der Lichtverarbeitungseinheit; und
Fokussieren von Optik (16) zum Erzeugen von Fokalregionen in einem Muster, das verarbeitet werden soll, wobei eine Fokalregion mit jeder Mikrolinse assoziiert ist,
wobei jede Steuerregion mit einer jeweiligen Mikrolinse assoziiert ist, **dadurch gekennzeichnet, dass** jede Steuerregion
eine Pixel-Unteranordnung umfasst, wobei jede Pixel-Unteranordnung in einen ersten Zustand steuerbar ist, um einen einzelnen Fokus in der Fokalregion bereitzustellen, bei dem Licht mit einer gleichförmigen Phase von der Steuerregion ausgegeben wird, und in einen zweiten Zustand, um vielfache Fokalpunkte mit niedrigerer Intensität in der Fokalregion bereitzustellen, bei denen Licht mit einem nicht gleichförmigen Phasenmuster von der Steuerregion ausgegeben wird.

2. System nach Anspruch 1, wobei jede Pixel-Unteranordnung in einen weiteren Zustand steuerbar ist, um einen versetzten Hauptfokus in der Fokalregion bereitzustellen, bei dem ein Licht mit einem linearen Phasengradienten von der Steuerregion ausgegeben wird.

3. System nach Anspruch 1 oder 2, wobei jede Pixel-Unteranordnung in einen weiteren Zustand steuerbar ist, um einen Hauptfokus mit reduzierter Intensität in der Fokalregion bereitzustellen, bei dem Licht mit einer gleichförmigen Phase von einer Mehrzahl der Pixel und Licht mit einer entgegengesetzten Phase von der verbleibenden Minderheit der Pixel von der Steuerregion ausgegeben wird.

4. System nach einem vorherigen Anspruch, wobei jede Pixel-Unteranordnung steuerbar ist, um ein gewünschtes vielfaches Fokalpunktmuster in der Fokalregion zu erzeugen, bei dem Licht mit einem vorbestimmten Phasenmuster von der Steuerregion ausgegeben wird.

5. System nach einem vorherigen Anspruch, ferner umfassend ein interferometrisches System assoziiert mit dem räumlichen Lichtmodulator und der Mikrolinsenanordnung, und das angeordnet ist, um eine konstruktive oder destruktive Interferenz an der Mikrolinsenanordnung bereitzustellen.

6. System nach einem vorherigen Anspruch, wobei der räumliche Lichtmodulator steuerbar ist, um einen Phasenmusterausgang bereitzustellen, der darin resultiert, dass Licht auf bestimmte Mikrolinsen und nicht auf andere gerichtet wird.

7. System nach einem der Ansprüche 1 bis 5, umfassend einen zusätzlichen räumlichen Eingangslichtmodulator, wobei der räumliche Eingangslichtmodulator steuerbar ist, um einen Phasenmusterausgang bereitzustellen, der darin resultiert, dass Licht auf bestimmte Regionen des anderen räumlichen Lichtmodulators und nicht auf andere gerichtet wird.

8. System nach einem vorherigen Anspruch, umfassend ein optisches Bildgebungssystem zwischen der steuerbaren Lichtverarbeitungseinheit und der Mikrolinsenanordnung.

9. Laserfertigungsverfahren, umfassend:
Richten eines Laserausgangs auf eine steuerbare Lichtverarbeitungseinheit umfassend einen räumlichen Lichtmodulator, der eine Pixel-Anordnung umfasst, wobei jedes Pixel steuerbar ist, um die Phase des Lichtausgangs von dem Pixel zu variieren, wobei die Lichtverarbeitungseinheit eine Anordnung von Steuerregionen umfasst;
unabhängiges Steuern einer Lichteigenschaft des Lichtausgangs von jeder
Steuerregion und Richten des Lichtausgangs auf eine Mikrolinsenanordnung, wobei die Lichteigenschaft die Phase umfasst, und wobei jede Steuerregion mit einer jeweiligen Mikrolinse assoziiert ist und eine Pixel-Unteranordnung umfasst;
Erzeugen einer Reihe von Fokalregionen in einem Muster, das verarbeitet werden soll, wobei eine Fokalregion mit jeder Mikrolinse assoziiert ist, und
Steuern jeder Pixel-Unteranordnung in einen ersten Zustand, um einen einzelnen Fokus in der Fokalregion bereitzustellen, bei dem Licht mit einer gleichförmigen Phase von der Steuerregion ausgegeben wird, und in einen zweiten Zustand, um vielfache Fokalpunkte mit niedrigerer Intensität in der Fokalregion bereitzustellen, bei denen Licht mit einem nicht gleichförmigen Phasenmuster von der Steuerregion ausgegeben wird.

10. Verfahren nach Anspruch 9, wobei die Steuerung einer Lichteigenschaft eines Lichtausgangs von jeder Steuerregion ferner angepasst werden kann, um:
einen seitlich versetzten Hauptfokus in der Fokalregion durch Ausgeben von Licht mit einem linearen Phasengradienten von der Steuerregion bereitzustellen, oder
einen in der Tiefe versetzten Hauptfokus in der Fokalregion durch Ausgeben von Licht mit einem quadratischen Phasenmuster von der Steuerregion bereitzustellen, oder
einen Hauptfokus mit reduzierter Intensität in der Fokalregion durch Ausgeben von Licht mit einem linearen Phasengradienten von einer Mehrheit der Pixel und Licht mit einer entgegengesetzten Phase von der verbleibenden Minderheit von der Steuerregion bereitzustellen, oder
ein gewünschtes vielfaches Fokalpunktmuster in der Fokalregion durch Ausgeben von Licht mit einem vorbestimmten Phasenmuster von der Steuerregion zu erzeugen, oder
einen Phasenmusterausgang bereitzustellen, der darin resultiert, dass Licht auf bestimmte Mikrolinsen und nicht auf andere gerichtet wird.

## Revendications

1. Système de fabrication laser pour le traitement d'un échantillon, comprenant :
un laser (10) ;
une unité de traitement à lumière contrôlable (12) comprenant un modulateur de lumière spatial comprenant un réseau de pixels, chaque pixel étant contrôlable pour varier la phase de la sortie de lumière du pixel, l'unité de traitement à lumière comprenant un réseau de zones de contrôle du pixel, afin de contrôler indépendamment une caractéristique de lumière de la lumière produite par chaque région de contrôle ;
un réseau de micro lentilles (14) dans le chemin optique de la lumière produite par les régions de contrôle de l'unité de traitement à lumière ; et
optique de focalisation (16) pour générer une série de régions focales dans un échantillon à traiter, une région focale associée avec chaque microlentille,
chaque région de contrôle étant associée avec une microlentille correspondante, **caractérisée en ce que** chaque région de contrôle
comprend un sous-réseau de pixels, chaque sous-réseau de pixels étant contrôlable dans un premier état pour fournir une focalisation unique dans la région focale, dans laquelle la lumière avec une phase uniforme est produite par la région de contrôle, et un deuxième état pour fournir de multiples points focaux d'intensité inférieure dans la région focale, dans laquelle la lumière avec un diagramme de phase non uniforme est produite par la région de contrôle.

2. Système selon la revendication 1, chaque sous-réseau de pixels pouvant être contrôlé dans un état additionnel pour fournir une focalisation principale déplacée depuis la région de contrôle, dans lequel une lumière à gradient de phase linéaire est produite par la région de contrôle.

3. Système selon la revendication 1 ou 2, chaque sous-réseau de pixels pouvant être contrôlé dans un état additionnel pour fournir une focalisation principale d'intensité réduite dans la région focale, dans laquelle une lumière à phase uniforme provenant d'une majorité de pixels, et une lumière à phase opposée provenant de la minorité restante des pixels est produite depuis la région de contrôle.

4. Système selon une quelconque des revendications précédentes, chaque sous-réseau de pixels pouvant être contrôlé pour produire une configuration désirée à multiples points focaux dans la région focale, dans lequel de la lumière avec un diagramme de phase prédéterminé est produite depuis la région de contrôle.

5. Système selon une quelconque des revendications précédentes, comprenant en outre un système interférométrique associé avec le modulateur de lumière spatial et le réseau de microlentilles, et agencé de façon à fournir une interférence constructive ou destructive au réseau de microlentilles.

6. Système selon une quelconque des revendications précédentes, le modulateur de lumière spatial pouvant être contrôlé pour effectuer la production d'un diagramme de phase, engendrant la direction de la lumière à certaines microlentilles et pas d'autres.

7. Système selon une quelconque des revendications 1 à 5, comprenant un modulateur de lumière spatial d'entrée additionnel, le modulateur de lumière spatial d'entrée pouvant être contrôlé pour effectuer la production d'un diagramme de phase, engendrant la direction de la lumière à certaines régions du modulateur de lumière spatial et pas d'autres.

8. Système selon une quelconque des revendications précédentes, comprenant un système d'imagerie optique entre l'unité de traitement à lumière contrôlable et le réseau de microlentilles.

9. Méthode de fabrication laser, comprenant les étapes suivantes :
diriger un faisceau laser à une unité de traitement à lumière contrôlable comprenant un modulateur de lumière spatial comprenant un réseau de pixels, chaque pixel pouvant être contrôlé pour varier la phase de la lumière produite par le pixel, l'unité de traitement de la lumière comprenant un réseau de régions de contrôle ;
contrôler indépendamment une caractéristique de lumière de la lumière produite par chaque région de contrôle, et diriger la lumière produite à un réseau de microlentilles, la caractéristique de la lumière comprenant la phase, et chaque région de contrôle étant associée avec une micro lentille correspondante, et comprenant un sous-réseau de pixels ;
générer un ensemble de régions focales dans un échantillon à traiter, une région focale étant associée avec chaque microlentille, et
contrôler chaque sous-réseau de pixels dans un premier état pour fournir une focalisation unique dans la région focale, dans laquelle de la lumière avec une phase uniforme est produite par la région de contrôle, et un deuxième état pour fournir de multiples points focaux d'intensité inférieure dans la région focale, dans laquelle la lumière avec un diagramme de phase non uniforme est produite par la région de contrôle.

10. Méthode selon la revendication 9, le contrôle d'une caractéristique de lumière produite par chaque région de contrôle étant adaptable en outre pour :
fournir une focalisation principale déplacée latéralement dans la région focale en produisant de la lumière avec un gradient de phase linéaire provenant de la région de contrôle, ou
fournir une focalisation principale déplacée dans le sens de la profondeur dans la région focale en produisant de la lumière avec un modèle de phase quadratique d'après la région de contrôle, ou
fournir une focalisation principale d'intensité réduite dans la région de focalisation en sortant de la lumière avec un gradient de phase uniforme provenant d'une majorité de pixels et d'une lumière à phase opposée provenant de la minorité restante de la région de contrôle, ou
produire une configuration désirée à multiples points focaux dans la région focale en produisant de la lumière avec un diagramme de phase prédéterminé depuis la région de contrôle, ou
produire un diagramme de phase sous l'effet duquel la lumière est dirigée vers certaines microlentilles et pas d'autres.
